# EUROPÄISCHE PATENTANMELDUNG

(11) **EP 1 318 706 A1**
(43) Veröffentlichungstag der Anmeldung: **11.06.2003**
(21) Anmeldenummer: 01129052.5
(22) Anmeldetag: 07.12.2001
(51) Int. Cl.: H05K 3/04

(54) **Verfahren und Vorrichtung zur Herstellung von elektrisch leitfähigen Mustern auf Trägern, sowie Folien dazu**

(71) Anmelder: Horst J. Lindemann GmbH, 21244 Buchholz (DE); Pasquini und Kromer GmbH, 70794 Filderstadt (DE)
(72) Erfinder: Lindemann, Horst Joern, 21244 Buchholz (DE); Kromer, Peter, 70771 Leinfelden-Echterdingen (DE); Pasquini, Jean-François, 70771 Leinfelden-Echterdingen (DE)
(74) Vertreter: Rach, Werner, Dr.

(57) **Zusammenfassung**

Die Erfindung beschreibt Verfahren zur Herstellung von elektrisch leitfähigen Mustern auf Trägern, insbesondere aus Kupfer, wobei die Muster selbst ein elektrisches Bauteil sein können und/oder elektrische Bauteile miteinander verbinden, sowie eine dazu geeignete Folie (1, 13). Das Muster wird mittels Heißprägung auf einen flexiblen Träger (3) übertragen. Die Übertragung erfolgt von einer Folie, die ein Kunststoff-Trägerband (110) enthält, auf dem eine Schicht (114) aus leitfähigem Material aufgebracht ist, und wobei zwischen der Schicht aus leitfähigem Material und dem Kunststoff-Trägerband eine Wachs- oder Trennschicht (112) und auf der Schicht aus leitfähigem Material gegebenenfalls eine Klebstoffschicht (115) vorgesehen ist. Bei der Übertragung erfolgt Wärmeeinwirkung über vorstehende Musterteile (20) eines Heißprägestempels (2) auf die Unterseite (111) des Kunststoff-Trägerbandes mit einer derartigen Temperatur, dass die Wachs- bzw. Trennschicht das direkt über dem berührenden Musterteil befindliche Material der Schicht aus leitfähigem Material freigibt und mittels des darüber befindlichen Klebstoffes mustergenau auf den flexiblen Träger übertragen wird. Die Klebstoffschicht kann sowohl auf dem flexiblen Träger als auch auf der Schicht aus leitfähigem Material als auch auf beiden aufgebracht sein.

## Beschreibung

Die Erfindung betrifft ein Verfahren zur Herstellung von elektrisch leitfähigen Mustern auf Trägern, insbesondere aus Kupfer, wobei die Muster selbst ein elektrisches Bauteil sein können und/oder elektrische Bauteile miteinander verbinden, gemäß der im Oberbegriff der Ansprüche 1 und 2 definierten Gattung. Die Erfindung betrifft weiterhin eine Vorrichtung zur Durchführung dieser Verfahren sowie Folien dazu.

Auf dem Markt sind elektrisch leitfähigen Mustern auf Trägern, insbesondere aus Kupfer, wobei die Muster selbst ein elektrisches Bauteil sein können und/oder elektrische Bauteile miteinander verbinden, allgemein als sogenannte gedruckte Schaltungen bekannt. Sogenannte Leiterplatten mit Leitungs- und/oder Bauteilmustern haben dabei einen festen Träger, auf dem entweder im Siebdruckverfahren die Leiterbahnen aufgedruckt oder im Ätzverfahren hergestellt werden. Diese Technik ist oft aufwendig und mit erheblicher Umweltbelastung durch die Verwendung von Chemikalien und Energie verbunden.

Im Bereich von Sicherheitsetiketten ist es bekannt, auf diese Weise - Siebdruck bzw. Ätztechnik - hergestellte Transponder auf Folien aufzubringen und dort mit in entsprechende Ausnehmungen eingesetzte Chips zu verbinden, um Sicherheitsetiketten herzustellen, die über die als Antenne wirkenden Transponder aktivier- und ansteuerbar sind. Die Transponder sind vorzugsweise aus Kupfer hergestellte Leitungsmuster, die selbst in Folienform angeliefert werden, jedoch in der vorstehend erwähnten üblichen Siebdruck- bzw. Ätztechnik vorher gefertigt werden.

Aus der DE 31 16 078 A1 ist eine Prägefolie zum Aufbringen von Leiterbahnen auf z.B. isolierende Unterlagen bekannt. Dabei ist die Prägefolie aufgebaut aus einer Haftschicht und einer elektrisch leitenden Schicht und einer Trennschicht sowie einem Trägerband. Die elektrisch leitende Schicht ist mit einer so geringen Scherfestigkeit versehen, dass Leiterbahnen oder auch elektrische Bauelemente mit ähnlicher Dicke, z.B. 10 bis 25 µm, wie bei üblichen gedruckten Schaltungen prägbar sind. Die leitende Schicht weist senkrecht zur Schichtebene ein faseriges oder faserig-körniges Kristallgefüge auf. Aufgabengemäß wird auf eine feste Unterlage, die als mechanisch funktionelles Teil in einem Gerät dient, die Prägung mittels eines beheizten Prägestempels vorgenommen. Bei dieser bekannten Folie und der beschriebenen Prägung ist weder die Übertragung einer leitfähigen Schicht auf einen flexiblen Träger noch eine Prägung mit effektiver Geschwindigkeit, insbesondere in einem Rotationsprägevorgang vorgesehen.

In der DE 43 04 212 C2 ist die Verwendung einer Transferfolie zum Bedrucken einer Unterlage in einem kontinuierlich arbeitenden Foliendruckverfahren beschrieben. Die Transferfolie setzt zusammen aus einem Trägerfilm, einer darunter angeordneten, lösbaren Trennschicht, einer durchscheinend aufgebauten Lackschicht, einer darunter angeordneten, vorzugsweise aufgedampften Metallschicht sowie einer dem Trägerfilm abgewandten außenliegenden Versiegelungsschicht besteht. Bei der Verarbeitung der Transferfolie wird diese unter Einwirkung eines sehr hohen Pressdruckes mit der Versiegelungsschicht auf die zu bedruckende Unterlage aufgebracht. Die zu Dekorationszwecken zu bedruckende Unterlage ist hierbei an den zur Folienübertragung vorgesehenen Stellenmit einem eigenen Kleber versehen. Er geht bereits bei Raumtemperatur mit der selbst nicht klebenden Versiegelungsschicht eine innige Verbindung ein. Anschließend wird der Trägerfilm mit der Trennschicht von der Lackschicht gelöst. Durch diese schimmert die Metallisierung in der gewünschten dekorativen Weise durch. Eine Herstellung elektisch leitfähiger Muster oder Bauteile wie im Sinne vorliegender Erfindung ist hier weder beschrieben noch beabsichtigt oder nahe gelegt.

Aus der DE 197 00 299 A1 ist ein Heißprägeverfahren bzw. eine Heißprägevorrichtung zum Übertragen von Musterelementen auf einen Träger bekannt. Dabei wird die zwischen einem Heißprägezylinder und einem Gegendruckzylinder hindurchlaufende Heißprägefolie schrittweise mit einem jeweils der Größe der Musterelemente entsprechenden Vorschub angetrieben, wodurch erhebliche Einsparungen an Folienmaterial erzielt wird. Nach einer Möglichkeit werden die auf den Träger zu übertragenden Musterelemente durch erhabene Bereiche des Heißprägezylinders definiert. Nach einer anderen Möglichkeit werden die auf der Musterfolie vorhandenen Einzelmuster jeweils in Gänze übertragen.

Aufgabe vorliegender Erfindung ist es, ein Verfahren und eine Vorrichtung zur effektiven, kostengünstigen und einfachen Herstellung von elektrisch leitfähigen Mustern auf Trägern, insbesondere aus Kupfer, wobei die Muster selbst ein elektrisches Bauteil sein können und/oder elektrische Bauteile miteinander verbinden, anzugeben sowie eine dazu geeignete vorteilhafte Folie anzugeben, welche vorteilhaft gegenüber den bekannten Verfahren und Vorrichtungen ist und deren Nachteile vermeidet.

Diese Aufgabe wird mit Hilfe von zwei im Ansatz unterschiedlichen Ausgangslagen her gelöst.

Vorteile der Erfindung

Diese Aufgabe wird entsprechend dem ersten Ansatz verfahrerisgemäß dadurch gelöst, dass das Muster mittels Heißprägung auf einen flexiblen Träger übertragen wird, die Übertragung von einer Folie erfolgt, wobei die Folie ein Kunststoff-Trägerband enthält, auf dem eine Schicht aus leitfähigem Material aufgebracht ist, und wobei zwischen der Schicht aus leitfähigem Material und dem Kunststoff-Trägerband eine Wachsschicht und auf der Schicht aus leitfähigem Material eine Klebstoffschicht vorgesehen ist, und bei der Übertragung die Wärmeeinwirkung auf die Unterseite des Kunststoff-Trägerbandes mit einer derartigen Temperatur erfolgt, dass das Wachs direkt über dem berührenden Musterteil schmilzt und das darüber befindliche Material der Schicht aus leitfähigem Material mittels des darüber befindlichen Klebstoffes mustergenau auf den flexiblen Träger übertragen wird.

Diese Aufgabe wird entsprechend dem zweiten Ansatz verfahrensgemäß dadurch gelöst, dass das Muster mittels Heißprägung auf einen flexiblen Träger übertragen wird, auf dem flexiblen Träger eine Klebstoffschicht vorgesehen ist, die Übertragung von einer Folie erfolgt, wobei die Folie ein Kunststoff-Trägerband enthält, auf dem eine Schicht aus leitfähigem Material aufgebracht ist, und wobei zwischen der Schicht aus leitfähigem Material und dem Kunststoff-Trägerband eine Trennschicht oder eine Wachsschicht vorgesehen ist, und bei der Übertragung die Wärmeeinwirkung auf die Unterseite des Kunststoff-Trägerbandes mit einer derartigen Temperatur erfolgt, dass direkt über dem berührenden Musterteil das leitfähige Material sich im Bereich der Trennschicht löst oder das Wachs dort schmilzt und somit das darüber befindliche Material der Schicht aus leitfähigem Material mittels des darüber auf dem flexiblen Träger befindlichen Klebstoffes mustergenau auf den flexiblen Träger übertragen und dort gehalten wird

In vorteilhafter Weise wird mittels dieser Verfahren eine einfache, kostengünstige und umweltschonende Erzeugung elektrisch leitender Muster auf flexiblem Träger ermöglicht und zwar in einer Weise, die produktionstechnisch hohe Fertigungsgeschwindigkeiten und Mengen gestattet.

Entsprechend vorteilhafter Ausgestaltung der erfindungsgemäßen Verfahren ist sowohl auf der Schicht aus leitfähigem Material als auch auf dem flexiblen Träger eine Klebstoffschicht vorgesehen.

Eine besonders vorteilhafte und für hohe Effektivität sorgende Weiterbildung der erfindungsgemäßen Verfahren sieht vor, die Wärmezufuhr bei der Heißprägung sowohl allein auf der Seite der Folie oder allein auf der Seite des flexiblen Trägers oder auch gleichzeitig auf beiden Seiten vorzunehmen.

Entsprechend vorteilhafter Ausgestaltung der erfindungsgemäßen Verfahren erfolgt die Übertragung vorzugsweise mit einer Temperatur von 170° - 300° Celsius.

In weiterer sehr zweckmäßiger Ausgestaltung der Erfindung erfolgt die Übertragung rotativ kontinuierlich mit linienförmigem Kontakt. Gemäß einer dazu vorteilhaften Alternativlösung, die je nach Produktionsziel einsetzbar ist, erfolgt die Übertragung schrittweise diskontinuierlich mit flächigem Kontakt.

In vorteilhafter Weiterbildung der erfindungsgemäßen Verfahren ist oder wird das durch Übertragung mittels Heißprägung auf dem flexiblen Träger entstandene Muster aus elektrisch leitfähigem Material mit einer Schutzschicht versehen. Gemäß einer besonderen Ausgestaltung der Erfindung sind als elektrisch leitfähiges Material Kupfer, Aluminium und/oder andere elektrisch leitfähige Stoffe in der entsprechenden Schicht vorgesehen.

Die der Erfindung zugrundeliegende Aufgabe wird vorrichtungsmäßig prinzipiell dadurch gelöst, dass das zu übertragende Muster auf einem Heißprägestempel vorgesehen ist. Entsprechend vorteilhafter Weiterbildung der erfindungsgemäßen Vorrichtung ist der Heißprägestempel ein Rotationsprägezylinder oder ein flächiger Prägestempel. Damit können entweder kontinuierlich die Muster mit hohen Produktionsgeschwindigkeiten übertragen werden oder im Takt auf den flexiblen Träger übertragen werden, wenn dies dem angestrebten Produktionsziel besser dient.

Gemäß vorteilhafter Ausgestaltung der erfindungsgemäßen Vorrichtung ist für den Heißprägestempel und gegebenenfalls auch für das Gegendrucklager des Heißprägestempels eine elektrisch, mit Öl, mit Laser oder mit Ultraschall betriebene Heizung vorgesehen.

Entsprechend einer vorteilhaften Weiterbildung der erfindungsgemäßen Vorrichtung ist eine Vorwärmekammer bzw. ein Vorwärmesystem vorgesehen, durch welche die elektrisch leitfähiges Material enthaltende Folie und/oder der mit der Klebstoffschicht versehene flexible Träger vor der Übertragung hindurchläuft. Dies hat den besonderen Vorteil, dass dadurch die Folie und gegebenenfalls auch der flexible Träger vor der Übertragung bereits vorgewärmt ist und dann am eigentlichen Übertragungsort die Übertragung sicher, effektiv, schnell und mustergenau erfolgt. In zweckmäßiger Ausgestaltung ist die Vorwärmekammer bzw. das Vorwärmesystem durch einen Abschluss verschließbar, welcher bei Anhalten der Bewegung der Folie und Abheben des Heißprägestempels die Kammer öffnend verschiebbar ist. Damit ist sichergestellt, dass die angehaltene Folie bzw. der angehaltene flexible Träger keinen Schaden nimmt. Vorteilhaft wird die Vorwärmkammer bzw. das Vorwärmesystem durch die Führung des Heißprägestempels verschlossen. Wird dieser beim Anhalten angehoben, wird die Vorwärmekammer nach außen hin geöffnet und die Wärme kann entweichen, so dass die Folie keinen Schaden nimmt. Ähnliches kann beim Gegendrucklager hinsichtlich des flexiblen Trägers vorgesehen sein.

In weiterer vorteilhafter Ausgestaltung der erfindungsgemäßen Vorrichtung ist zur Aufbringung einer Schutzschicht auf dem durch Übertragung mittels Heißprägung auf dem flexiblen Träger entstandenen Muster aus elektrisch leitfähigem Material, eine Laminierstation zum Aufbringen einer Schutzfolie oder eine Besprühstation zum Aufsprühen einer Schutzschicht vorgesehen. Auf diese Weise kann die elektrisch leitende Schicht nach der Übertragung des Musters gegen Korrosion wirksam geschützt werden.

Entsprechend einem weiteren ganz wesentlichen Aspekt vorliegender Erfindung ist die Folie, die insbesondere zur Verwendung in einem Verfahren gemäß der Erfindung oder in einer Vorrichtung gemäß der Erfindung besonders geeignet ist, dadurch gekennzeichnet, dass sie ein Kunststoff-Trägerband enthält, auf dem eine Wachsschicht oder eine Trennschicht und darauf eine Schicht aus elektrisch leitfähigem Material aufgebracht ist und dass die Schicht aus elektrisch leitfähigem Material gegebenenfalls mit einer Schicht aus Klebstoff abgedeckt ist.

Entsprechend einer ganz wesentlichen und zweckmäßigen Weiterbildung der erfindungsgemäß gestalteten Folie sind als elektrisch leitfähiges Material in der Schicht aus elektrisch leitfähigem Material Kupfer, Aluminium und/oder andere elektrisch leitfähige Stoffe vorgesehen.

Eine weitere vorteilhafte Ausgestaltung der Folie besteht darin, dass zwischen der Wachsschicht oder der Trennschicht und der Schicht aus elektrisch leitfähigem Material eine diese schützende Abdeckschicht vorgesehen ist. Diese Form der Folie erübrigt ein separates Aufbringen eine Schutzfolie oder Aufsprühen einer entsprechenden Schutzschicht. Vorteilhaft besteht die schützende Abdeckschicht aus einem Prägelack.

Eine besonders zweckmäßige Ausgestaltung der erfindungsgemäßen Folie ist dadurch gekennzeichnet, dass das Kunststoff-Trägerband eine Dicke von etwa 12 - 50 µm aufweist, die Wachsschicht oder die Trennschicht etwa 1 - 2 µm dick ist bzw. aus ca. 1,5 - 2 g/m² Releaselack gebildet wird, die Schichtdicke der Schicht aus elektrisch leitfähigem Material, insbesondere wenn sie als elektrisch leitfähiges Material Kupfer enthält, zwischen 0,08 µm und etwa 4 µm liegt, und die gegebenenfalls vorgesehene Schicht aus Klebstoff etwa 2 - 4 µm beträgt bzw. aus ca. 2 - 4 g/m² Klebelack besteht. Die eventuell zwischen der Wachsschicht oder Trennschicht und der Schicht aus elektrisch leitfähigem Material vorhandene und diese schützende Abdeckschicht kann eine Dicke von etwa 1 - 4 µm haben bzw. aus ca. 1 - 4 g/m² Prägelack, gegebenenfalls mit Basislack, bestehen.

### Zeichnung

Die erfindungsgemäßen Verfahren sind anhand von in der Zeichnung dargestellten Ausführungsbeispielen der erfindungsgemäß gestalteten Vorrichtung zur Durchführung des Verfahrens sowie der erfindungsgemäß gestalteten Folien in der nachfolgenden Beschreibung näher erläutert. Die Figuren zeigen im Einzelnen:
- Fig.1: in schematisierter Schnitt-Darstellung eine erste, eine Schutzschicht enthaltende Ausführungsform der Folie gemäß der Erfindung zusammen mit einem Teil eines Heißprägestempels;
- Fig. 2: schematisch in Schnitt-Darstellung eine zweite, eine anders aufgebaute Schutzschicht enthaltende Ausführungsform der Folie gemäß der Erfindung zusammen mit einem Teil eines Heißprägestempels;
- Fig. 3: in schematisierter Schnitt-Darstellung eine dritte, keine Schutzschicht enthaltende Ausführungsform der Folie gemäß der Erfindung zusammen mit einem Teil eines Heißprägestempels;
- Fig. 4: schematisch in Draufsicht das Leiterbahnbild eines Transponders, welcher als Antenne dient;
- Fig. 5: schematisch in Seitenansicht eine rotative Ausführungsform der Erfindung mit einem Rotationsprägezylinder als Heißprägestempel, und

- Fig. 6: in schematisierter Schnitt-Darstellung eine zweite, eine Schutzschicht enthaltende Ausführungsform der Folie gemäß dem zweiten Verfahren der Erfindung, bei dem die Klebeschicht auf dem flexiblen Träger vorgesehen ist, zusammen mit angedeutetem Heißprägestempel und zylindrischem Gegendrucklager.

### Beschreibung der Ausführungsbeispiele

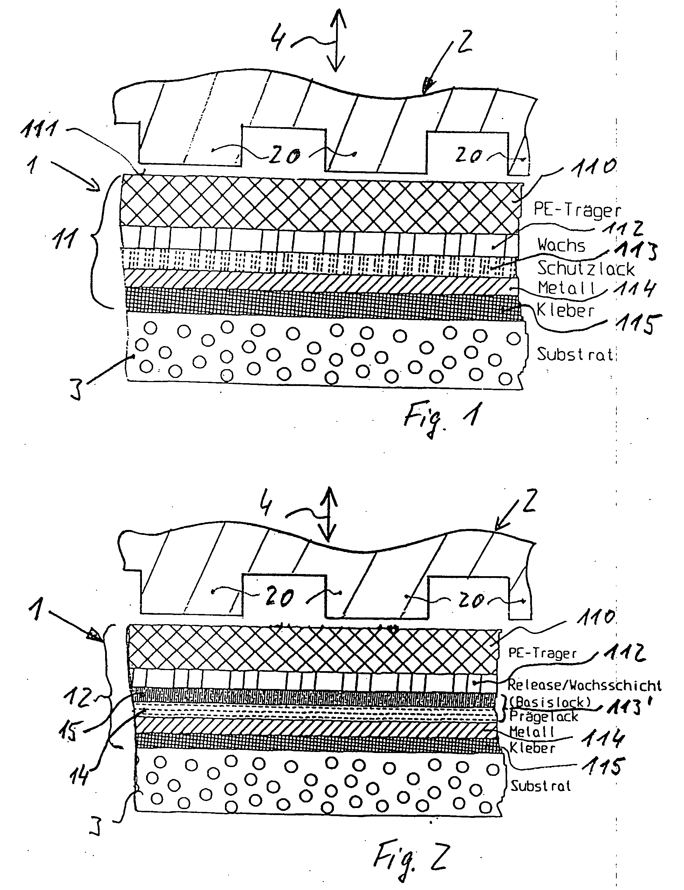

In Fig. 1 ist in schematisierter Schnitt-Darstellung eine erste Ausführungsform 11 der Folie 1 gemäß der Erfindung zusammen mit einem Teil eines Heißprägestempels 2 dargestellt. Die Folie 11 enthält ein Kunststoff-Trägerband 110, welches bevorzugt eine PET-Folie ist. Auf dem Kunststoff-Trägerband 110 ist eine Wachsschicht 112 aufgebracht. Des Weiteren enthält die Folie 11 in dieser Ausführungsform auf der Wachsschicht 112 Schutzschicht 112 aus schützendem Lack. Als nächstes enthält die Folie eine Schicht 114 aus elektrisch leitfähigem Material. Als elektrisch leitfähiges Material ist bevorzugt Kupfer vorgesehen. Es können auch Aluminium und/oder andere elektrisch leitfähige Stoffe verwendet werden. Über der Metallschicht 114 ist eine Kleberschicht 115 aufgebracht.

In der Darstellung von Fig. 1 ist weiterhin ein flexibler Träger 3 gezeigt, der als Substrat für die auf ihn übertragenen Teile der Folie 1 dient. Diese Teile sind die Klebschicht 115, die Metallschicht 114 und die Schutzschicht 113.

In Fig. 2 ist schematisch in Schnitt-Darstellung eine zweite Ausführungsform 12 der Folie 1 gemäß der Erfindung zusammen mit einem Teil eines Heißprägestempels und ähnlich der Anordnung von Fig. 1 dargestellt. Diese Ausführungsform 12 der Folie 1 enthält eine anders aufgebaute Schutzschicht 113', die aus einer Schicht 15 aus Basislack und aus einer Schicht 14 aus Prägelack besteht, wobei die Schicht 14 aus Prägelack die die Metallschicht 114 gegen Korrosion schützende Schicht ist.

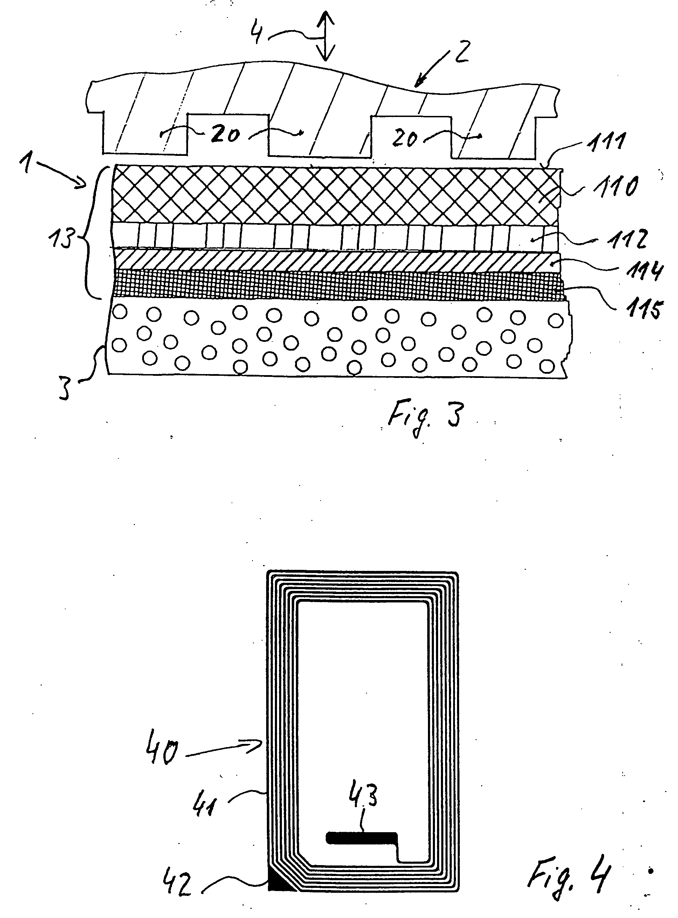

In Fig. 3 ist in schematisierter Schnitt-Darstellung eine dritte, keine Schutzschicht enthaltende Ausführungsform 13 der Folie 1 gemäß der Erfindung zusammen mit einem Teil eines Heißprägestempels 2 dargestellt. Bei dieser Ausführungsform ist die Möglichkeit vorgesehen, dass nach der Heißpräge-Übertragung entweder eine Schutzfolie auflaminiert wird oder eine schützende Lackschicht aufgesprüht wird. Dies ist in den Figuren im Einzelnen nicht dargestellt.

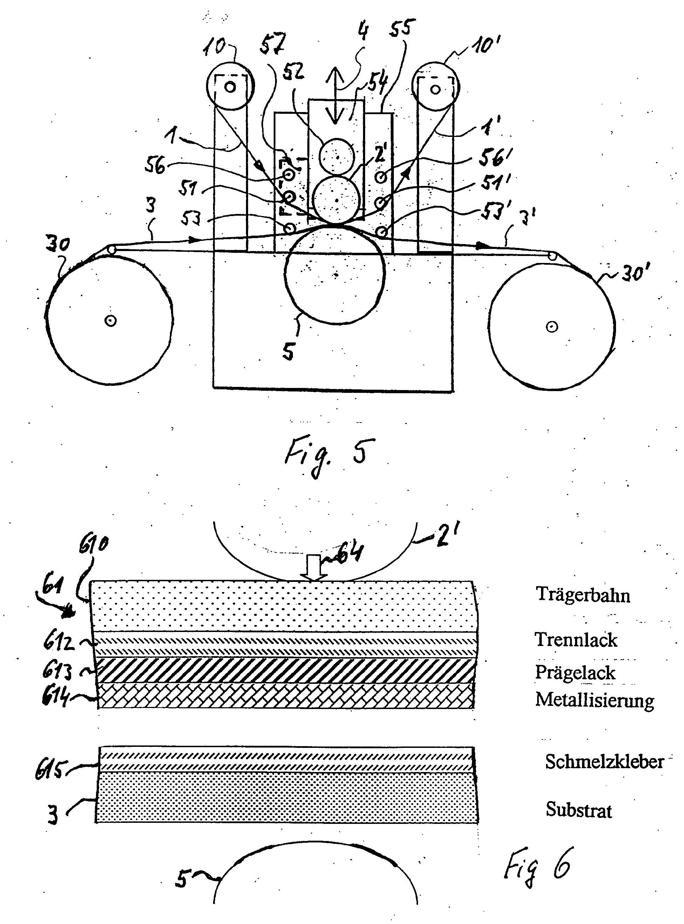

Beim erfindungsgemäßen Verfahren wird der Heißprägestempel 2 in Richtung des Doppelpfeiles 4 nach unten auf die Folie 1 gedrückt und damit in Richtung auf den flexiblen Träger 3, der von einer in Fig. 5 dargestellten, als Gegenlager dienenden Gegendruckrolle 5 getragen ist. Auf dem Heißprägestempel 2 sind die zu übertragenden Muster in der Weise aufgebracht, dass der Heißprägestempel 2 in Richtung auf die Folie 11 und den Träger 3 vorspringende Teile 20 aufweist. Diese sehen in der Darstellung von den Fig. 1 - 3 wie Zähne aus.

Die Wirkungsweise bei dem erfindungsgemäßen Verfahren ist nun folgende. Der Heißprägestempel 2 ist beheizt. Die Wärme wird durch die vorspringenden Teile 20, die mit der Unterseite 111 der Folie 1 bzw. damit deren Kunststoff-Trägerband 110 in Berührung stehen, auf die Kontaktierungsbereiche konzentriert und begrenzt durch dieses hindurch auf die Wachsschicht 112, die auch als Releaseoder Freigabe-Schicht bezeichnet werden kann, übertragen. Die Wärmeeinwirkung auf die Unterseite 111 des Kunststoff-Trägerbandes 110 erfolgt mit einer derartigen Temperatur, dass das Wachs der Wachsschicht 112 direkt über dem berührenden Musterteil 20 schmilzt und das darüber befindliche Material der Schicht aus leitfähigem Material 114 mittels des darüber befindlichen Klebstoffes der Kleberschicht 115 mustergenau auf den flexiblen Träger 3 übertragen wird. Vorzugsweise liegen die Übertragungstemperaturen im Bereich von 170° - 300° Celsius. Die Übertragung erfolgt rotativ kontinuierlich mit linienförmigem Kontakt mittels eines Rotationsprägezylinders 25 in Fig. 5 oder diskontinuierlich mit flächigem Kontakt mittels eines entsprechend flächig gestaltetem Heißprägestempel 2. Die Zuführung der Folie 1 und des flexiblen Trägers 3 sowie die Zustellung und Bewegung des Heißprägestempels 2 ist darauf jeweils passend abgestimmt. Die Heizung des Heißprägestempels 2 kann elektrisch, mit Öl, mit Laser oder Ultraschall erfolgen. Auch für das Gegendrucklager, insbesondere dann, wenn es aus einer Gegendruckrolle 5 besteht, kann eine elektrisch, mit Öl, mit Laser oder mit Ultraschall betriebene Heizung vorgesehen sein.

Die auf den flexiblen Träger 3 zu übertragenden Muster sind als hervorstehende, erhabene Teile 20 auf dem flachen oder zylinderförmigen Heißprägestempel 2 vorgesehen. In Fig. 4 ist als Beispiel eines solchen Musters 40 schematisch in Draufsicht das Leiterbahnbild eines Transponders, welcher als Antenne dient, gezeigt. Die in Form einer rechteckigen Spirale ausgeführte Leiterbahn 41 beginnt an einem dreieckförmigen ersten Anschlusspad 42 und endet in einem rechteckigen vergrößerten zweiten Anschlusspad 43. An diese Anschlusspads kann beispielsweise ein Bauteil wie ein entsprechendes Chip zur Bildung eines Sicherheitsetikettes elektrisch angeschlossen werden. Es ist klar und selbstverständlich, dass darüber hinaus eine Vielzahl anderer Muster möglich sind, die zum einen auf dem Heißprägestempel 2 vorgesehen sind und die zum anderen auf den flexiblen Träger 3 übertragbar sind. So können mit der Erfindung Leiterbahnmuster der klassischen gedruckten Schaltungen und Platinen hergestellt werden, die anschließend in Einschicht- und Mehrschichttechnik anwendbar sind. Die Erfindung eröffnet hier eine enorme Vielzahl von möglichen Mustern und bietet hohe Flexibilität in der Anwendung.

Gemäß dem zweiten Ansatz des erfindungsgemäßen Verfahrens ist die Klebstoffschicht, die das übertragene leitfähige Material auf dem flexiblen Träger hält, auf dem flexiblen Träger selbst vorgesehen. Ein Ausführungsbeispiel einer solchen Konstellation ist in Fig. 6 dargestellt. Sie zeigt in schematisierter Schnitt-Darstellung eine Folie 61, die ein Kunststoff-Trägerband 610 enthält. Darauf ist eine Trennschicht 612, die aus Wachs oder Trennlack bestehen kann, aufgebracht. In weiterer Folge ist eine Schutzschicht 613 vorgesehen, die aus Prägelack und gegebenenfalls zusätzlich aus Basislack, der nicht dargestellt ist, bestehen kann. Auf dieser Schutzschicht 613 ist eine aus leitfähigem Material bestehende Schicht 614 aufgebracht. Diese vorzugsweise aus Kupfer bestehende Schicht 614 kann auf die Folie 61 aufgedampft sein. Durch das erfindungsgemäße Verfahren wird diese Kupferschicht 614 auf den flexiblen Träger 3, auf dem eine aus Schmelzkleber bestehende Klebstoffschicht 615 aufgebracht ist, entsprechend dem Muster des Heißprägestempels 2 bzw. 2' übertragen.

Zur Übertragung wird die Folie 61 mit dem flexiblen Träger 3 als Substrat durch Verschiebung in Richtung des Pfeils 64 auf den nur schematisch angedeuteten Heißprägestempel, hier in Form eines Rotationsprägezylinders 2', und das Gegenlager, hier in Form eines Gegendruckzylinders 5, hin in Kontakt gebracht. Die dargestellte Form beinhaltet die vorzuziehende rotative Übertragung des auf dem Rotationsprägezylinders 2' vorgesehenen Musters und damit die entsprechende Übertragung der aus der elektrisch leitenden Schicht 614 an der Trennschicht 612 mustergemäß herausgetrennten Teile der elektrisch leitenden Schicht 614 auf die Klebstoffschicht 615 und den mit ihr verbundenen flexiblen Träger 3.

Bei der rotativen Übertragung laufen Folie 161 und flexibler Träger 3 zwischen den sich drehenden Rotationsprägezylinder 2' und Gegendruckzylinder 5 unter Druck und Wärmeeinwirkung hindurch. Neben der Heizung für den Heißprägestempel kann auch eine Heizung für das Gegendrucklager vorgesehen sein. Diese Heizung kann elektrisch, mit Öl , mit Laser oder mit Ultraschall betrieben werden. Insbesondere ist es bei der mit hoher Geschwindigkeit arbeitenden rotativen Übertragung von Vorteil, die Folie 61 und gegebenenfalls auch den flexiblen Träger 3 mit seiner Klebstoffschicht 615 durch ein Vorwärmsystem vorzuwärmen. Dies ist jedoch in Fig. 6 nicht dargestellt.

Der flexible Träger 3 besteht beispielsweise aus einem 23 µm dicken PET Trägerband oder einem LDPE-beschichteten Papierträgerband entsprechender Dicke, auf dem die aus Schmelzkleber bestehende Klebstoffschicht 615 aufgebracht ist. Dabei ist der flexible Träger 3 so vorbehandelt und das Material des Schmelzklebers der Klebstoffschicht 615 so ausgewählt und eingestellt, dass der Kleber, nach der Aktivierung durch Hitze und Druck, sowohl eine ausreichende Haftung zum Substrat behält als auch eine ausreichende Adhäsion mit der elektrisch leitenden Schicht 614 erzielt wird. Diese Form der Folie 61 vermeidet die Beanspruchung des leitfähigen Materials, insbesondere des aufgedampften Kupfers, in der Schicht aus leitfähigem Material durch Aufbringung einer Klebstoffschicht, wie es im ersten Verfahren gemäß der Erfindung vorgesehen ist.

Falls es sich in der Praxis jedoch als günstig erweist, kann auch eine Kombination beider Konstellationen vorgesehen sein, nämlich sowohl eine Klebstoffschicht 615 auf dem flexiblen Träger 3 als auch eine Klebstoffschicht 115 auf der elektrisch leitenden Schicht 114, die auf der Folie 1 gemäß Fig. 1 - 3 aufgebracht ist.

In Fig. 5 ist schematisch in Seitenansicht eine rotative Ausführungsform der Erfindung mit einem Rotationsprägezylinder 2' als Heißprägestempel 2 dargestellt. Von einer Zuführungsrolle 30 wird der folienförmige flexible Träger 3, auf den das Muster aufgeprägt werden soll, in geeignet gewählter Anschmiegung über eine Umlenkrolle 53 zwischen den als Heißprägestempel 2 dienenden Rotationsprägezylinder 2' und die als Auflage dienende Gegendruckrolle 5 geführt. Von der Übertragungsstelle, dem linienförmigen Berührungsbereich zwischen Rotationsprägezylinder 2' und Gegendruckrolle 5, wird der mit dem Muster versehene flexible Träger 3' über eine geeignet angeordnete Umlenkrolle 53' zu einer Aufwickelrolle 30' geführt und dort als fertiges Produkt aufgewickelt. Die Folie 1, welche die zu übertragende Schicht 114 mit dem elektrisch leitenden Material enthält, wird von einer Vorratsrolle 10 in geeignet gewählter Anschmiegung über eine geeignet angeordnete Umlenkrolle 51 ebenfalls zwischen den als Heißprägestempel 2 dienenden Rotationsprägezylinder 2' und die als Auflage dienende Gegendruckrolle 5 geführt. Von der Übertragungsstelle, dem linienförmigen Berührungsbereich zwischen Rotationsprägezylinder 2' und Gegendruckrolle 5, wird die Folie 1', aus der das Muster herausgeprägt wurde, über eine geeignet angeordnete Umlenkrolle 51' zu einer Aufwickelrolle 10' geführt und dort aufgewickelt. Durch zwei weitere dargestellte Umlenkrollen 56 und 56' kann die Folie 1 und 1' in einem anderen Winkel der Übertragungsstelle zugeführt und von ihr abgeführt werden. Die weitere Anpassung der Anschmiegung ist auch für den flexiblen Träger 3 möglich, jedoch sind keine entsprechenden Umlenkungen gezeigt.

Der Rotationsprägezylinder 2' ist zusammen mit einer Anpressrolle 52, die verstärkten Druck auf die Rotationsprägezylinder 2' ausübt, in einer Kulisse 54 angebracht, die in einer Tragaufnahme 55 in Richtung des Doppelpfeils 4 auf und ab bewegbar ist. Auf diese Weise können Rotationsprägezylinder 2' und Gegendruckrolle 5 mit der Folie 1 und dem flexiblen Träger 3 dazwischen entweder mit dem richtigen Druck zum Prägen zusammengebracht werden oder auseinandergefahren werden. Gestrichelt eingezeichnet ist im linken Teil der Tragaufnahme 55 eine Vorwärmekammer 57, durch die die Folie 1 vor der Heißprägung hindurch geleitet wird. Durch die Vorwärmung mittels eines Vorwärmesystems wird die eigentliche Heißprägung und damit die Musterübertragung wesentlich unterstützt und verbessert. Wird eine Folie entsprechend dem zweiten Verfahren nach der Erfindung verwendet, wobei die Klebstoffschicht auf dem flexiblen Träger vorgesehen ist, dann ist es von besonderem Vorteil auch dafür ein Vorwärmesystem vorzusehen. Die genannte Vorwärmekammer 57 ist durch einen Abschluss gegenüber der Umgebung verschließbar. Bei Bewegungsstillstand, wenn weder die Folie 1 noch der flexible Träger 3 vorgeschoben wird, wird sie durch Abheben des Heißprägestempels 2 bzw. 2' von der Gegendruckrolle 5 geöffnet. Damit steht die Vorwärmekammer 57 bei Stillstand mit der Umgebung im Wärmeaustausch, so dass die durchlaufende, dann stehende, Folie 1 keinen Schaden nimmt. Der Abschluss kann in vorteilhafter Ausgestaltung durch die Kulisse 54 gebildet werden. Wenn erforderlich ist eine solche Einrichtung auch für den flexiblen Träger 3 vorgesehen, besonders dann, wenn auf ihm allein entsprechend Fig. 6 oder zusätzlich eine Klebstoffschicht 615 vorgesehen ist.

Zwischen der Übertragungsstelle, dem linienförmigen Berührungsbereich zwischen Rotationsprägezylinder 2' und Gegendruckrolle 5, und der Aufwickelrolle 30' für den mit dem Muster versehenen flexiblen Träger 3' kann zur Aufbringung einer Schutzschicht auf dem durch Übertragung mittels Heißprägung auf dem flexiblen Träger entstandene Muster aus elektrisch leitfähigem Material, eine Laminierstation zum Aufbringen einer Schutzfolie oder eine Besprühstation zum Aufsprühen einer Schutzschicht vorgesehen sein. Dies ist in Fig. 5 nicht dargestellt. Vorteilhaft ist dies dann, wenn eine Folie 1 in der Ausführungsform 13 gemäß Fig. 3, das heißt ohne Schutzschicht, verarbeitet wird.

Entsprechend einem weiteren ganz wesentlichen Aspekt vorliegender Erfindung ist die Folie 1 oder 61, die insbesondere zur Verwendung in einem der Verfahren gemäß der Erfindung oder in einer Vorrichtung gemäß der Erfindung besonders geeignet ist, dadurch gekennzeichnet, dass sie ein Kunststoff-Trägerband 110 bzw. 610 enthält, auf dem eine Wachsschicht 112 oder eine Trennschicht 612 und darauf eine Schicht 114 bzw. 614 aus elektrisch leitfähigem Material aufgebracht ist und dass die Schicht aus elektrisch leitfähigem Material 114 bzw. 614 gegebenenfalls mit einer Schicht aus Klebstoff 115 abgedeckt ist. Entsprechend einer ganz wesentlichen und zweckmäßigen Weiterbildung der erfindungsgemäß gestalteten Folien 1 bzw. 61 ist als elektrisch leitfähiges Material in der Schicht 114 bzw. 614 aus elektrisch leitfähigem Material Kupfer vorgesehen.

Besonders vorteilhaft ist es weiterhin zwischen der Wachsschicht 112 oder der Trennschicht 612 und der Schicht 114 bzw. 614 aus elektrisch leitfähigem Material eine diese schützende Abdeckschicht 113 oder 113' bzw. 613 als Schutzschicht vorzusehen.

Diese Form der Folie erübrigt ein separates Aufbringen eine Schutzfolie oder Aufsprühen einer entsprechenden Schutzschicht.

Eine besonders zweckmäßige Ausgestaltung der erfindungsgemäßen Folie zeichnet sich dadurch aus, dass das Kunststoff-Trägerband 110 bzw. 610 eine Dicke von etwa 12 - 50 µm aufweist, die Wachsschicht 112 oder die Trennschicht 612 etwa 1 - 2 µm dick ist bzw. aus ca. 1,5 - 2 g/m² Releaselack gebildet wird, die Schichtdicke der Schicht 114 bzw. 614 aus elektrisch leitfähigem Material, insbesondere wenn sie als elektrisch leitfähiges Material Kupfer, Aluminium und/oder andere elektrisch leitfähige Stoffe enthält, zwischen 0,08 µm und etwa 4 µm liegt, und die Schicht 115 aus Klebstoff etwa 2 - 4 um beträgt bzw. aus ca. 2 - 4 g/m² Klebelack besteht.

Die eventuell zwischen der Wachsschicht 112 bzw. der Trennschicht 612 und der Schicht 114 bzw. 614 aus elektrisch leitfähigem Material vorhandene und diese schützende Abdeckschicht 113 bzw. 613 kann eine Dicke von etwa 1 - 4 µm haben bzw. aus ca. 1 - 4 g/m² Prägelack, gegebenenfalls mit Prägelack, gebildet sein. Die in Fig. 2 gezeigte Schutzschicht 113', die zwischen der Wachsschicht 112 und der Schicht 114 aus elektrisch leitfähigem Material vorhanden ist, besteht aus der Prägelackschicht 14 und der Basislackschicht 15. Diese beiden Schichten 14 und 15 haben zusammen oder einzeln etwa auch die Stärke von etwa 1 - 4 µm bzw. besteht aus ca. 1 - 4 g/m² Prägelack und gegebenenfalls aus ca. 1 - 4 g/m² Basislack.

Insgesamt bieten die erfindungsgemäß gestalteten Folien zusammen mit den erfindungsgemäßen Verfahren und der erfindungsgemäßen Vorrichtung eine vorteilhafte, kostengünstige, schnelle und überaus vielseitige Möglichkeit, um elektrisch leitfähige Muster auf flexiblen Trägern bzw. Substraten für eine Vielzahl von Anwendungen herzustellen.

## Patentansprüche

1. Verfahren zur Herstellung von elektrisch leitfähigen Mustern auf Trägern, insbesondere aus Kupfer, wobei die Muster selbst ein elektrisches Bauteil sein können und/oder elektrische Bauteile miteinander verbinden,
**dadurch gekennzeichnet, dass**
das Muster mittels Heißprägung auf einen flexiblen Träger übertragen wird,
die Übertragung von einer Folie erfolgt, wobei die Folie ein Kunststoff-Trägerband enthält, auf dem eine Schicht aus leitfähigem Material aufgebracht ist, und wobei zwischen der Schicht aus leitfähigem Material und dem Kunststoff-Trägerband eine Wachsschicht und auf der Schicht aus leitfähigem Material eine Klebstoffschicht vorgesehen ist, und
bei der Übertragung die Wärmeeinwirkung auf die Unterseite des Kunststoff-Trägerbandes mit einer derartigen Temperatur erfolgt, dass das Wachs direkt über dem berührenden Musterteil schmilzt und das darüber befindliche Material der Schicht aus leitfähigem Material mittels des darüber befindlichen Klebstoffes mustergenau auf den flexiblen Träger übertragen wird.

2. Verfahren zur Herstellung von elektrisch leitfähigen Mustern auf Trägern, insbesondere aus Kupfer, wobei die Muster selbst ein elektrisches Bauteil sein können und/oder elektrische Bauteile miteinander verbinden,
**dadurch gekennzeichnet, dass**
das Muster mittels Heißprägung auf einen flexiblen Träger übertragen wird,
auf dem flexiblen Träger eine Klebstoffschicht vorgesehen ist,
die Übertragung von einer Folie erfolgt, wobei die Folie ein Kunststoff-Trägerband enthält, auf dem eine Schicht aus leitfähigem Material aufgebracht ist, und wobei zwischen der Schicht aus leitfähigem Material und dem Kunststoff-Trägerband eine Trennschicht oder eine Wachsschicht vorgesehen ist, und
bei der Übertragung die Wärmeeinwirkung auf die Unterseite des Kunststoff-Trägerbandes mit einer derartigen Temperatur erfolgt, dass direkt über dem berührenden Musterteil das leitfähige Material sich im Bereich der Trennschicht löst oder das Wachs dort schmilzt und somit das darüber befindliche Material der Schicht aus leitfähigem Material mittels des darüber auf dem flexiblen Träger (Substrat) befindlichen Klebstoffes mustergenau auf den flexiblen Träger übertragen und dort gehalten wird.

3. Verfahren nach Anspruch 1 oder 2, **dadurch gekennzeichnet, dass** sowohl auf der Schicht aus leitfähigem Material als auch auf dem flexiblen Träger eine Klebstoffschicht vorgesehen ist.

4. Verfahren nach einem der Ansprüche 1 bis 3, **dadurch gekennzeichnet, dass** die Wärmezufuhr bei der Heißprägung sowohl allein auf der Seite der Folie oder allein auf der Seite des flexiblen Trägers als auch gleichzeitig auf beiden Seiten erfolgen kann.

5. Verfahren nach einem der vorigen Ansprüche, **dadurch gekennzeichnet, dass** die Übertragung vorzugsweise mit einer Temperatur von 170° - 300° Celsius erfolgt.

6. Verfahren nach einem der vorigen Ansprüche, **dadurch gekennzeichnet, dass** die Übertragung rotativ kontinuierlich mit linienförmigem Kontakt erfolgt.

7. Verfahren nach einem der Ansprüche 1 bis 5, **dadurch gekennzeichnet, dass** die Übertragung schrittweise diskontinuierlich mit flächigem Kontakt erfolgt.

8. Verfahren nach Anspruch 1 oder 2, oder einem der Ansprüche 3 bis 7, **dadurch gekennzeichnet, dass** das durch Übertragung mittels Heißprägung auf dem flexiblen Träger entstandene Muster aus elektrisch leitfähigem Material mit einer Schutzschicht versehen ist oder versehen wird.

9. Verfahren nach Anspruch 1 oder 2, oder einem der Ansprüche 3 bis 8, **dadurch gekennzeichnet, dass** als elektrisch leitfähiges Material Kupfer, Aluminium und/oder andere elektrisch leitfähige Stoffe in der entsprechenden Schicht vorgesehen ist.

10. Vorrichtung zum Durchführen des Verfahrens nach Anspruch 1 oder 2, oder einem der Ansprüche 3 bis 9, **dadurch gekennzeichnet, dass** das zu übertragende Muster (40) auf einem Heißprägestempel (2, 2') vorgesehen ist.

11. Vorrichtung nach Anspruch 10, **dadurch gekennzeichnet, dass** der Heißprägestempel (2) ein Rotationsprägezylinder (2') oder ein flächiger Prägestempel ist.

12. Vorrichtung nach Anspruch 10 oder 11, **dadurch gekennzeichnet, dass** für den Heißprägestempel (2, 2') eine elektrisch, mit Öl, mit Laser oder mit Ultraschall betriebene Heizung vorgesehen ist.

13. Vorrichtung nach Anspruch 12, **dadurch gekennzeichnet, dass** für das Gegendrucklager des Heißprägestempels (2, 2')') eine elektrisch, mit Öl, mit Laser oder mit Ultraschall betriebene Heizung vorgesehen ist.

14. Vorrichtung nach einem der Ansprüche 10 bis 13, **dadurch gekennzeichnet, dass** eine Vorwärmekammer (57) bzw. ein Vorwärmesystem vorgesehen ist, durch welche die elektrisch leitfähiges Material enthaltende Folie (1,61) und/oder der mit der Klebstoffschicht (115, 615) versehene flexible Träger (3) vor der Übertragung hindurchläuft.

15. Vorrichtung nach Anspruch 14, **dadurch gekennzeichnet, dass** die Vorwärmekammer (57) bzw. das Vorwärmesystem durch einen Abschluss (54) verschließbar ist, welcher bei Anhalten der Bewegung der Folie (1, 61) und Abheben des Heißprägestempels (2') die Vorwärmekammer (57) bzw. das Vorwärmesystem öffnend verschiebbar ist.

16. Vorrichtung nach einem der Ansprüche 10 bis 15, **dadurch gekennzeichnet, dass** zur Aufbringung einer Schutzschicht (113, 113'; 613) auf dem durch Übertragung mittels Heißprägung auf dem flexiblen Träger (3, 3') entstandene Muster (40) aus elektrisch leitfähigem Material, eine Laminierstation zum Aufbringen einer Schutzfolie oder eine Besprühstation zum Aufsprühen einer Schutzschicht vorgesehen ist.

17. Folie (1, 61), insbesondere zur Verwendung in einem Verfahren nach Anspruch 1 oder 2 und einem der Ansprüche 3 bis 9 oder in einer Vorrichtung nach einem der Ansprüche 10 bis 16,
**dadurch gekennzeichnet, dass**
sie ein Kunststoff-Trägerband (110; 610) enthält, auf dem eine Wachsschicht (112) oder eine Trennschicht (612) und darauf eine Schicht (114; 614) aus elektrisch leitfähigem Material aufgebracht ist und dass die Schicht (114; 614) aus elektrisch leitfähigem Material gegebenenfalls mit einer Schicht (115) aus Klebstoff abgedeckt ist.

18. Folie nach Anspruch 17, **dadurch gekennzeichnet, dass** als elektrisch leitfähiges Material in der Schicht (114; 614) aus elektrisch leitfähigem Material Kupfer, Aluminium und/oder andere elektrisch leitfähige Stoffe vorgesehen ist.

19. Folie nach Anspruch 17 oder 18, **dadurch gekennzeichnet, dass** zwischen der Wachsschicht (112) oder der Trennschicht (612) und der Schicht (114; 614)) aus elektrisch leitfähigem Material eine diese schützende Abdeckschicht (113, 113'; 613) vorgesehen ist.

20. Folie nach Anspruch 19, **dadurch gekennzeichnet, dass** die schützende Abdeckschicht (113, 113'; 613) eine Schicht aus Prägelack ist.

21. Folie nach einem der Ansprüche 17 bis 20, **dadurch gekennzeichnet, dass** das Kunststoff-Trägerband (110; 610) eine Dicke von etwa 12 - 50 µm aufweist, die Wachsschicht (112) oder die Trennschicht (612) etwa 1 - 2 µm dick ist bzw. aus ca. 1,5 - 2 g/m² Release- bzw. Trennlack gebildet wird, die Schichtdicke der Schicht (114; 614) aus elektrisch leitfähigem Material, insbesondere wenn sie als elektrisch leitfähiges Material Kupfer, Aluminium und/oder andere elektrisch leitfähige Stoffe enthält, zwischen 0,08 µm und etwa 4 µm liegt, und die gegebenenfalls vorgesehene Schicht (115) aus Klebstoff etwa 2 - 4 µm beträgt bzw. aus ca. 2 - 4 g/m² Klebelack besteht.

22. Folie nach Anspruch 21, **dadurch gekennzeichnet, dass** die zwischen der Wachsschicht (112) oder Trennschicht (612) und der Schicht (114; 614) aus elektrisch leitfähigem Material vorhandene und diese schützende Abdeckschicht (113, 113'; 613) eine Dicke von etwa 1 - 4 µm hat bzw. aus ca. 1 - 4 g/m² Prägelack, gegebenenfalls mit Basislack, besteht.
